(19) **Europäisches Patentamt**
**European Patent Office**
**Office européen des brevets**

(11) **EP 4 431 955 B1**

(12) **FASCICULE DE BREVET EUROPEEN**

(45) Date de publication et mention
de la délivrance du brevet:
**01.10.2025 Bulletin 2025/40**

(21) Numéro de dépôt: **24162525.0**

(22) Date de dépôt: **10.03.2024**

(51) Classification Internationale des Brevets (IPC):
**G01R 31/08** (2020.01)     **G01R 31/52** (2020.01)

(52) Classification Coopérative des Brevets (CPC):
**G01R 31/52; G01R 31/085;** G01R 31/088

(54) **PROCÉDÉ DE DÉTECTION D'UN DÉFAUT SUR UNE SECTION D ALIMENTATION ÉLECTRIQUE D'UN RÉSEAU FERROVIAIRE ET DISPOSITIF ASSOCIÉ**

VERFAHREN ZUR ERKENNUNG EINES FEHLERS AUF EINEM ELEKTRISCHEN LEISTUNGSABSCHNITT EINES EISENBAHNNETZES UND VORRICHTUNG DAFÜR

METHOD FOR DETECTING A FAULT ON AN ELECTRICAL SUPPLY SECTION OF A RAILWAY NETWORK AND ASSOCIATED DEVICE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.03.2023 FR 2302370**

(43) Date de publication de la demande:
**18.09.2024 Bulletin 2024/38**

(73) Titulaire: **Supergrid Institute**
**69100 Villeurbanne (FR)**

(72) Inventeurs:
• **LANZAROTTO, Damiano**
**69007 LYON (FR)**
• **WALLART, François**
**69007 LYON (FR)**

(74) Mandataire: **Opilex**
**32, rue Victor Lagrange**
**69007 Lyon (FR)**

(56) Documents cités:
EP-A1- 2 186 706     EP-A1- 3 997 471
US-A1- 2012 004 867     US-A1- 2021 141 010

**Description**

Le domaine de la présente invention est relatif aux réseaux d'alimentation électrique d'un réseau ferroviaire et plus particulièrement à un procédé de détection d'un défaut sur une section d'alimentation électrique d'un réseau ferroviaire, un procédé de protection et à des dispositifs associés.

On connaît dans le cadre des réseaux ferroviaires des lignes aériennes d'alimentation électrique d'un véhicule également appelée lignes aériennes de contact lorsqu'elle ne comporte qu'un ou deux fils de contact.

Une ligne aérienne d'alimentation électrique est appelée caténaire lorsqu'elle est constituée d'un ou deux fils de contact suspendus par des pendules à un ou deux câbles porteurs. Le câble porteur est lui-même maintenu, à intervalles réguliers, par des potences. Le câble porteur, sous l'effet de son propre poids, prend la forme d'une chaînette et les pendules ont des hauteurs adaptées de manière à ce que le fils de contact soit suspendu sensiblement horizontalement.

Le véhicule électrique, par exemple une motrice, locomotive électrique ou tram est alors alimenté par captage du courant circulant sur le fil de contact au moyen d'un pantographe monté sur la toiture du véhicule et déployé pour venir en contact du fil de contact.

Selon un autre exemple, le courant électrique peut être apporté au véhicule électrique via un patin frotteur qui est en contact avec un rail d'alimentation électrique spécifique.

Dans le présent document, par véhicule électrique, on entend tout véhicule propre à capter du courant sur une telle ligne électrique d'alimentation, par voie aérienne de contact ou via un rail d'alimentation électrique. Il s'agit par exemple de véhicules électriques guidés (train, tramway, métro etc.) ou non guidés (trolleybus, voiture, etc.).

Pour la sécurité de fonctionnement du réseau d'alimentation et plus particulièrement pour la sécurité des conducteurs, des passagers et des personnes à proximité directe de l'installation, il est important que le réseau d'alimentation soit surveillé et puisse être interrompu rapidement en cas de dysfonctionnement.

Un tel cas de dysfonctionnement peut par exemple être la rupture du fil de contact d'une ligne aérienne de contact, un défaut d'isolation au niveau de l'accroche de la caténaire ou alors par exemple une chute d'arbre sur la caténaire. Cela constitue un incident généralement dangereux pouvant survenir notamment aux passages à niveau ou par fusion au niveau du pantographe d'un train arrêté.

Une fois rompu, le fil de contact pend ou tombe au sol. Étant porté à un potentiel élevé, il présente alors un risque important d'électrocution pour les personnes se trouvant dans la zone avoisinant le point de rupture.

Un tel incident peut se caractériser dans certains cas, notamment lorsque la caténaire touche les rails pour un réseau DC à 1.5kV, par un phénomène transitoire qui conduit à une élévation du courant très importante et très rapide.

Pour pallier ce problème, des sections d'alimentation des lignes d'alimentation électrique d'un réseau ferroviaire sont équipées de dispositifs de protection qui mesurent le courant circulant et coupent le courant sur toute la section en question si le courant est trop élevé par rapport à des valeurs nominales.

Toutefois, il a été constaté que la protection ne peut pas toujours être assurée de façon fiable lorsque le défaut est localisé loin d'une sous-station car l'impédance présentée par la caténaire elle-même limite à la fois l'amplitude du courant de défaut et son taux d'accroissement.

D'un autre côté, il existe d'autres phénomènes transitoires comme par exemple le décollement d'un pantographe d'une caténaire qui dans certains cas peuvent déclencher les systèmes de protection mis en place. On peut aussi citer par exemple le démarrage de locomotives anciennes sans onduleur. Toutefois, dans la majorité des cas, il ne s'agit pas de phénomènes nécessitant la coupure de courant dans une section d'alimentation électrique.

US 2012/004867 A1 divulgue un procédé de détection de défauts sur une section d'une ligne électrique selon l'état de la technique .

La présente invention a pour objet un procédé amélioré de détection d'un défaut sur une section d'une ligne d'alimentation électrique d'un réseau ferroviaire.

A cet effet, la présente invention concerne un procédé de détection d'un défaut sur une section d'une ligne électrique d'alimentation d'un réseau ferroviaire, comprenant les étapes suivantes :

- on mesure un courant sur la section en fonction du temps pendant une fenêtre temporelle de mesure d'une durée prédéfinie,
- on détermine des paramètres d'au moins une fonction de modélisation paramétrable modélisant la courbe de mesure du courant en fonction du temps, cette fonction de modélisation paramétrable présentant une composante croissante asymptotique avec au moins un paramètre définissant la valeur asymptotique du courant en régime établi et au moins un paramètre correspondant à une constante de temps définissant une durée d'établissement du régime établi,
- on détermine la présence ou non d'un défaut à partir d'au moins certains desdits paramètres déterminés de ladite fonction de modélisation paramétrable.

Le procédé de détection peut comporter en outre un ou plusieurs des aspects suivants pris seuls ou en combinaison :

La fenêtre temporelle possède par exemple une durée inférieure à 200ms notamment inférieure à 100ms et par exemple comprise entre 30ms et 50ms, en particulier égal à 40ms.

La composante croissante asymptotique de la fonction peut être décrite par une fonc-tion du type ( $I_\infty - I_\Delta e^{-\frac{t}{\tau}}$ ), où $I_\infty$ représente le paramètre définissant la valeur asymptotique du courant en régime établi et $\tau$ représente le paramètre correspondant à une constante de temps définissant une durée d'établissement du régime établi.

La fonction de modélisation paramétrable comprend en outre notamment une composante additionnelle oscillatoire.

La fonction de modélisation paramétrable du courant $i_p(t)$ en fonction du temps est définie par

$$i_P(t) = p_1 + [I_0 - p_3 \sin(p_5) - p_1]e^{-\frac{t}{p_2}} + p_3 sin(2\pi p_4 t + p_5)$$

Avec

$$\begin{cases} p_1 = I_\infty \\ p_2 = \tau \\ p_3 = I_h \\ p_4 = f_h \\ p_5 = \alpha_h \end{cases}$$

où $I_\infty$ représente le paramètre correspondant au courant établi en fin de de régime transitoire,

$\tau$ représente le paramètre correspondant au paramètre de temps permettant de définir la durée du phénomène transitoire,

$I_h$ représente un paramètre correspondant à une amplitude de l'harmonique de courant du phénomène transitoire dans le terme oscillatoire qui peut être égal à $I_\Delta$,

$f_h$ représente un paramètre correspondant à une fréquence dans le terme oscillatoire décrivant le phénomène transitoire et

$\alpha_h$ représente un cinquième paramètre correspondant à une phase du terme oscillatoire décrivant le phénomène transitoire.

La fonction du courant $i_p(t)$ en fonction du temps peut être définie en prenant en compte davantage de paramètre par :

$$i_P(t) = p_1 + [I_0 - I_{00} - p_1]e^{-t/p_2} + \sum_{k=1}^{m} p_{3,k} sin \left(2\pi\, p_{4,k} t + p_{5,k}\right)$$

$$I_{00} = \sum_{k=1}^{m} p_{3,k} sin \left(p_{5,k}\right)$$

avec : $p_1 = I_\infty$, $p_2 = \tau$ et $p_{3,k}$, $p_{4,k}$ et $p_{5,k}$ des paramètres correspondant respectivement à des amplitudes de courant, des fréquences et des déphasages.

Selon le procédé, on peut appliquer aux paramètres déterminés $p_1 = I_\infty$, $p_2 = \tau$ et $p_{3,k}$, $p_{4,k}$ et $p_{5,k}$ une analyse des composantes principales pour obtenir de nouvelles variables décorrélées et on détermine la présence ou non d'un défaut à partir d'au moins une desdites nouvelles variables décorrélées.

Selon le procédé, avant de déterminer la présence ou non d'un défaut, on vérifie notamment si $I_\infty > I_0$ et $I_0 > 0$, si une de ces inégalités n'est pas vérifiée, on détermine qu'il n'y a pas de défaut.

La modélisation de la courbe de mesure par la fonction de modélisation paramétrable peut être réalisée par application d'une méthode aux moindres carrées.

On peut déclencher le début de la fenêtre temporelle de mesure quand le courant mesuré franchi un seuil prédéfini.

Selon une variante ou comme condition supplémentaire, on déclenche par exemple le début de la fenêtre

## EP 4 431 955 B1

temporelle de mesure quand la dérivée dans le temps du courant mesuré franchi un seuil prédéfini.

On détermine la présence ou non d'un défaut en déterminant par exemple l'appartenance d'au moins un paramètre déterminé à une région de défaut obtenue par un processus d'apprentissage et/ou de classification, à partir de mesures réelles ou obtenues par simulation de défauts sur un modèle d'une section d'alimentation électrique entre deux sous-stations surveillées ou par une combinaison des deux.

L'invention concerne également un dispositif de détection d'un défaut sur une section sur d'une ligne électrique d'alimentation d'un réseau ferroviaire comprenant un capteur de mesure de courant et étant configuré pour mettre en œuvre un procédé de protection tel que défini ci-dessus.

L'invention concerne en outre un procédé de protection d'une section d'une ligne électrique d'alimentation d'un réseau ferroviaire, dans lequel chaque section est équipée de plusieurs dispositifs de protection, chaque dispositif de protection comprenant un capteur de mesure de courant et est configuré pour mettre en œuvre un procédé de détection d'un défaut tel que défini ci-dessus, et dans lequel on déclenche tous les dispositifs de protection d'une même section lorsqu'on a déterminé un défaut par au moins un dispositif de protection.

Enfin l'invention concerne un dispositif de protection d'une section d'une ligne électrique d'alimentation d'un réseau ferroviaire comprenant un capteur de mesure de courant et étant configuré pour mettre en œuvre un procédé de protection tel que défini ci-dessus.

D'autres caractéristiques et avantages de l'invention ressortiront de la description suivante, donnée à titre d'exemple et sans caractère limitatif, en regard des dessins annexés sur lesquels :

[Fig 1] la figure 1 montre un schéma simplifié d'une ligne d'alimentation électrique d'un réseau ferroviaire en courant continu,

[Fig 2] la figure 2 montre un schéma similaire à celui de la figure 1 avec des dispositifs de protection,

[Fig 3] la figure 3 est un graphe du courant en fonction du temps pour illustrer le procédé de l'invention,

[Fig 4] la figure 4 est un organigramme pour illustrer certaines étapes du procédé de l'invention,

[Fig 5] la figure 5 est un premier exemple de résultat obtenu avec le procédé selon l'invention,

[Fig 6] la figure 6 est un deuxième exemple de résultat obtenu avec le procédé selon l'invention,

[Fig 7] la figure 7 est un troisième exemple de résultat obtenu avec le procédé selon l'invention, et

[Fig 8] la figure 8 est un quatrième exemple de résultat obtenu avec le procédé selon l'invention.

Sur toutes les figures, les éléments ayant des fonctions identiques portent les mêmes numéros de référence.

Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

Dans son principe, le système de traction électrique ferroviaire est composé par des installations fixes (sous-stations, caténaires, rails) et par le matériel roulant (train de fret ou de voyageurs tracté par une locomotive). Dans la plupart des cas, l'alimentation en énergie électrique de la locomotive est assurée via une ligne aérienne appelée la caténaire. Un pantographe, équipé d'un frotteur, permet au véhicule électrique de capter le courant.

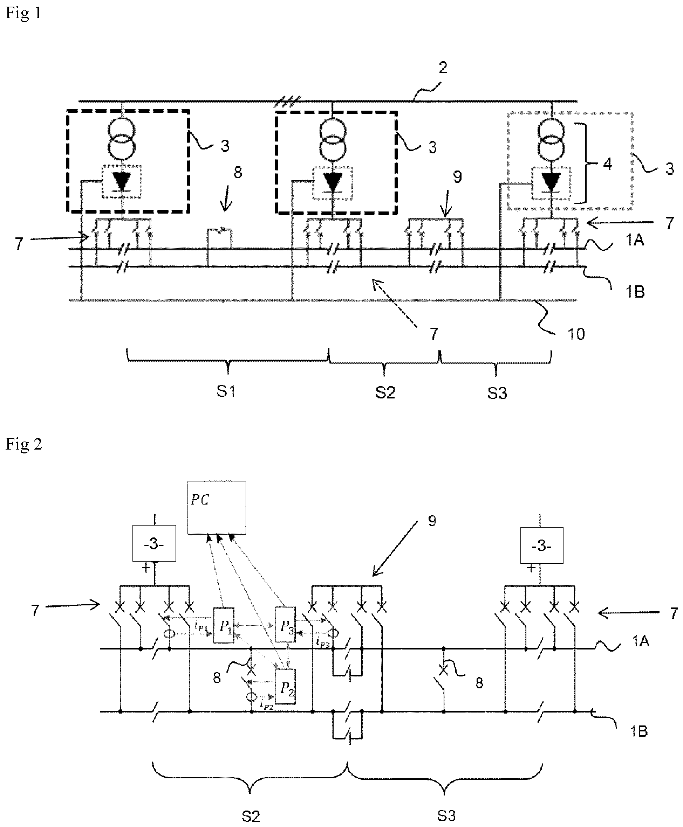

La figure 1 montre un schéma simplifié pour alimenter au moins une, dans le présent cas deux lignes d'alimentation électrique 1A et 1B d'un réseau ferroviaire en courant continu.

La référence 2 désigne le réseau électrique public d'un fournisseur d'énergie électrique, par exemple en courant alternatif à plusieurs dizaines de kV à une fréquence de 50Hz.

Le réseau public 2 est raccordé à des sous-stations 3. Il s'agit plus spécifiquement par exemple d'un groupe transformateur / redresseur 4 situé dans la sous-station 3. Le groupe transformateur / redresseur 4 a pour fonction de convertir le courant alternatif haute tension du réseau public 2 en un courant continue de moyenne tension, par exemple de 1,5kV ou 3kV.

La sortie d'un groupe transformateur / redresseur 4, notamment à diodes de puissance est relié aux lignes aérienne 1A et 1B (les caténaires) via des dispositifs de coupure de courant 7 comme par exemple des disjoncteurs.

La ligne aérienne 1A est par exemple prévue pour alimenter des véhicules électriques sur une première voie, par exemple une voie aller et la ligne aérienne 1B est par exemple prévue pour alimenter des véhicules électriques sur une seconde voie, parallèle à la première, par exemple une voie retour.

Pour équilibrer la tension d'alimentation entre les voies aller - retour, des postes de mise en parallèle 8 et des postes mixtes de mise en parallèle et de sous-sectionnement 9 sont prévus, par exemple tous les 10 à 15km. Pour la protection de la ligne vis-à-vis d'un court-circuit caténaire-rail, des disjoncteurs rapides sont installés dans les postes de mise en parallèle 8, dans les postes mixtes 9 de mise en parallèle et de sous-sectionnement et en sortie des sous- stations 3.

Les lignes aériennes 1A et 1B entre deux sous-stations 3 ou entre une sous-station 3 et un poste mixte 9 de mise en parallèle et de sous-sectionnement font partie de la même section S du réseau d'alimentation électrique du réseau ferroviaire. Une section S d'une ligne d'alimentation 1A ou 1B peut être isolée électriquement par des interrupteurs ou des disjoncteurs des autres sections.

Sur la figure 1 sont représentées à titre d'exemple les sections S1, S2 et S3.

Enfin sur la figure 1 sont représentés par la référence 10 des rails (deux voies) qui sont reliés à un pôle basse tension et sur lesquels vont circuler les véhicules électriques.

La figure 2 montre un schéma similaire à celui de la figure 1 avec des dispositifs de protection désignés dans le présent exemple par P1, P2 et P3 et qui protègent la même section S2 de ligne électrique d'alimentation, dans le présent cas la ligne 1A. Le dispositif de protection P1 peut être intégré dans une sous-station 3, le dispositif de protection P2 dans un poste 8 de mise en parallèle et le dispositif de protection P3 par exemple dans un poste mixte 9 de mise en parallèle et de sous-sectionnement. Sur la figure 2, les rails 9 et le réseau public 2 ne sont pas représentés.

Comme on peut le voir sur la figure 2, les dispositifs de protection P1, P2 et P3 sont équipés de moyens de communication (schématiquement représentés par des flèches), par exemple filaires, optiques ou aériens, de sorte à pouvoir communiquer d'une part avec un poste centrale PC de surveillance. Par ailleurs, il existe aussi un asservissement commun entre les dispositifs de protection P1, P2 et P3 de sorte que, si une des protections du disjoncteur alimentant la ligne se déclenche, cela ouvre non seulement le disjoncteur localement mais aussi les autres disjoncteurs via lesquels cette section est alimentée.

En particulier chaque dispositif de protection P1, P2 et P3 est configuré pour d'une part mettre en œuvre un procédé de détection d'un défaut qui sera détaillé ci-après, communiquer aux autres dispositifs de protection de la même section d'alimentation électrique la demande d'ouverture et d'autre part si besoin, communiquer la détection d'un défaut au poste centrale PC.

Lorsqu'au moins l'un des dispositifs de protection par exemple P1 détecte un défaut sur la section par exemple S2 à protéger, il est configuré pour envoyer un signal aux autres dispositifs de protection, par exemple P2 et P3 de la même section S2 ce qui a pour effet de déclencher aussi ces derniers et donc d'isoler rapidement la section d'alimentation électrique S2 où le défaut a été détecté.

Chaque dispositif de protection P1, P2 ou P3 est équipé d'un capteur de courant (représenté sur la figure 2 par une boucle de mesure de courant) qui est par exemple disposé à proximité d'un interrupteur qui peut être commandé (schématiquement représenté par des flèches) par le dispositif de protection.

Ainsi, un capteur de courant est par exemple disposé sur la ligne d'alimentation électrique en aval d'un interrupteur pour mesurer un courant $I_{P1}$ qui sera traité ensuite par le dispositif P1 et en fonction du résultat, le dispositif P1 est configuré pour ouvrir l'interrupteur en question en cas de défaut ou de le laisser fermé si le transitoire détecté n'est pas considéré comme un défaut nécessitant une isolation de la section S2 de la ligne d'alimentation électrique 1A.

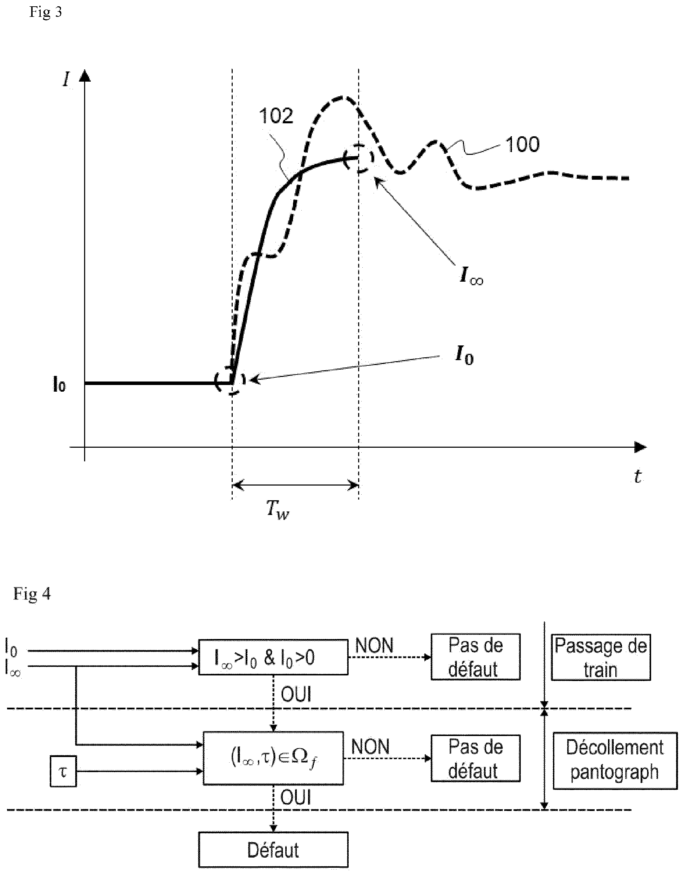

Le procédé de détection d'un défaut sera détaillé ci-après en regard des figures 3 et 4.

Sur la figure 3 est montré de façon schématique et simplifié en trait pointillé avec la référence 100 un exemple d'une mesure du courant I en fonction du temps t.

Cette mesure est réalisée pendant une fenêtre temporelle de mesure d'une durée prédéfinie $T_W$ par exemple par un des dispositifs de protection P1, P2 ou P3 qui sont tous équipés avec des capteurs de courant à cet effet comme précédemment décrits.

Des phénomènes transitoires sont des perturbations sur une ligne d'alimentation électrique ferroviaire se caractérisent généralement par une élévation anormalement rapide de courant, puis par l'atteinte d'une valeur élevée et plutôt constante de courant. En fonction de la nature du phénomène transitoire, par exemple coupure d'un fil de caténaire ou décrochement / rebondissement du pantographe du véhicule électrique de la ligne d'alimentation électrique, une isolation électrique par exemple d'une section S2 par actionnement des dispositifs de protection P1, P2 et P3 peut être nécessaire ou non.

La fenêtre temporelle $T_W$ possède notamment une durée inférieure à 200ms notamment inférieure à 100ms et par exemple comprise entre 30ms et 50ms, en particulier égal à 40ms. La durée de la fenêtre temporelle de mesure $T_W$ est un compromis entre d'une part la précision que l'on souhaite obtenir pour la modélisation de cette courbe de mesure 100 et d'autre part la rapidité avec laquelle on souhaite déclencher les dispositifs de protection P1, P2 et P3 de la section d'alimentation électrique S2 afin d'isoler électriquement cette section S2 pour éloigner les dangers pour les personnes qui peuvent se trouver à proximité du défaut.

Comme on le voit sur la figure 3, au départ, avant le déclenchement de la fenêtre de mesure $T_W$, le courant I est constant et égal à $I_0$. Il s'agit d'un courant nominal $I_0$ qui circule par exemple dans la ligne aérienne 1A dans la cadre d'un fonctionnement nominal. Bien entendu, la valeur du courant nominal $I_0$ dépend des conditions de fonctionnement, en particulier du fait si et combien de véhicules électriques sont alimentés en même temps par une même section S d'alimentation électrique.

Le début de la fenêtre temporelle de mesure $T_W$ est déterminé par la détection d'un évènement déclencheur qui peut être précurseur de l'avènement d'un défaut. Un évènement déclencheur peut être une élévation importante de la dérivée du courant $dI(t)/dt$, ou une combinaison avec un autre évènement déclencheur.

Ainsi, après avoir mesuré le courant sur la section en fonction du temps pendant une fenêtre temporelle de mesure d'une durée prédéfinie $T_W$, on modélise la courbe de mesure du courant I(t) en fonction du temps.

Pour ce faire, on détermine des paramètres d'au moins une fonction de modélisation paramétrable modélisant la courbe de mesure du courant en fonction du temps. Cette fonction 102 de modélisation paramétrable présente une composante croissante asymptotique avec au moins un paramètre définissant la valeur asymptotique du courant en régime établi et au moins un paramètre correspondant à une constante de temps définissant une durée d'établissement du régime établi.

Sur la figure 3, une telle fonction qui est une fonction continue pour la fenêtre de temps $T_W$ est représentée en trait plein et référencée par 102.

Plus spécifiquement, la composante croissante asymptotique de la fonction 102 peut être décrite par une fonction du type

$$(I_\infty - I_\Delta e^{-\frac{t}{\tau}})$$

où $I_\infty$ représente le paramètre définissant la valeur asymptotique du courant en régime établi et $\tau$ représente le paramètre correspondant à une constante de temps définissant une durée d'établissement du régime établi. Dans cette fonction $I_\Delta$ peut être $I_\Delta = I_\infty - I_0$ et correspond en quelque sorte à l'amplitude d'élévation du courant.

La précision de modélisation peut être améliorée en ajoutant à la ladite fonction continue une composante additionnelle oscillatoire.

Dans ce cas, selon un premier mode de réalisation simplifié la fonction du courant $i_p(t)$ pour un dispositif de protection en fonction du temps est par exemple définie par

$$i_P(t) = p_1 + [I_0 - p_3 \sin(p_5) - p_1]e^{\frac{t}{p_2}} + p_3 sin(2\pi p_4 t + p_5)$$

avec

$$\begin{cases} p_1 = I_\infty \\ p_2 = \tau \\ p_3 = I_h \\ p_4 = f_h \\ p_5 = \alpha_h \end{cases}$$

où $I_\infty$ représente le premier paramètre et correspond au courant établi en fin de de régime transitoire,

$\tau$ représente le second paramètre et correspond à un paramètre de temps permettant de définir la durée du phénomène transitoire,

$I_h$ représente un troisième paramètre correspondant à une amplitude de l'harmonique de courant du phénomène transitoire dans le terme oscillatoire qui peut être égal à $I_\Delta$,

$f_h$ représente un quatrième paramètre correspondant à une fréquence dans le terme oscillatoire décrivant le phénomène transitoire et

$\alpha_h$ représente un cinquième paramètre correspondant à une phase du terme oscillatoire décrivant le phénomène transitoire.

Pour la modélisation et donc pour déterminer les paramètres de la fonction de modélisation, on minimise l'écart entre la mesure de courant et la fonction 102 dans la fenêtre de temps $T_W$, par exemple par application d'une méthode aux moindres carrées.

Puis on détermine la présence ou non d'un défaut à partir d'au moins certains desdits paramètres déterminés de ladite fonction de modélisation 102 paramétrable, notamment en déterminant si au moins un des paramètres appartient à une région de défaut appelé $\Omega$ (voir dernière étape représentée sur l'organigramme de la figure 4).

La région de défaut $\Omega$ peut être déterminée par exemple par un processus d'apprentissage et/ou de classification, à partir de mesures réelles ou obtenues par simulation de défauts sur un modèle d'une section d'alimentation électrique entre deux sous-stations surveillées ou par une combinaison des deux.

Si la région de défaut $\Omega$ est déterminée par simulation, on modélise au plus près la topologie du réseau d'alimentation électrique à surveiller.

L'infrastructure du système électrique doit bien représenter le réseau électrique d'alimentation réel. Par conséquent, toutes les simulations mentionnées ci-dessous doivent tenir compte des configurations différentes.

En particulier, on simule le réseau d'alimentation électrique à surveiller dans de nombreuses conditions de fonctionnement différentes pour représenter un maximum de situations possibles pour délimiter la région de défaut au plus précis.

Pour ce faire, les simulations doivent prendre en compte les défauts dans différentes localisations sur le réseau d'alimentation électrique, et notamment lorsqu'aucun train ne circule et lorsqu'un ou plusieurs trains circulent. On doit aussi tenir compte de différentes valeurs de la puissance absorbée par les sous-stations 3. Il faut également simuler des événements hors défaut, comme les rebonds de pantographe dans différentes positions de la ligne d'alimentation électrique et ceci pour différentes valeurs de puissance. Dans cette délimitation de la région de défaut on réalise aussi des simulations de démarrages de véhicules électriques dans différentes localisation du réseau et les transitoires déclenchés par exemple par un train traversant une sous-station 3 ou un poste 8 de mise en parallèle, ou un poste mixte 9, ceci à différentes vitesses et puissances.

Il peut être judicieux de vérifier avant la détermination si par exemple le couple de premier paramètre / second paramètre est comprise dans une région de défaut $\Omega$, si les conditions suivantes sont cumulativement remplies :

$$I_\infty > I_{0,}$$

et

$$I_0 > 0.$$

En effet, si une de ces deux inégalités n'est pas vérifiée, on détermine qu'il n'y a pas de défaut (voir première étape représentée sur l'organigramme de la figure 4).

Pour encore davantage de précision dans la modélisation de la courbe mesuré 100, on peut définir plus généralement ladite fonction 102 du courant $i_p(t)$ en fonction du temps par :

$$i_p(t) = p_1 + [I_0 - I_{00} - p_1]e^{-t/p_2} + \sum_{k=1}^{m} p_{3,k} sin(2\pi\, p_{4,k}\, t + p_{5,k})$$

$$I_{00} = \sum_{k=1}^{m} p_{3,k} sin(p_{5,k})$$

avec : $p_1 = I_\infty$, $p_2 = \tau$ et $p_{3,k}$, $p_{4,k}$ et $p_{5,k}$ des paramètres correspondant respectivement à des amplitudes de courant, des fréquences et des déphasages.

Dans ce cas on peut déterminer une multitude de paramètres et pour savoir si au moins par exemple les premier et second paramètres sont dans la région de défaut, on applique une analyse des composantes principales (méthode mathématique bien connue) aux paramètres déterminés $p_1 = I_\infty$, $p_2 = \tau$ et $p_{3,k}$, $p_{4,k}$ et $p_{5,k}$ pour obtenir de nouvelles variables décorrélées et on détermine la présence ou non d'un défaut à partir d'au moins une desdites nouvelles variables décorrélées. La région de défaut peut être en fonction du nombre de paramètres pris en compte multidimensionnelle.

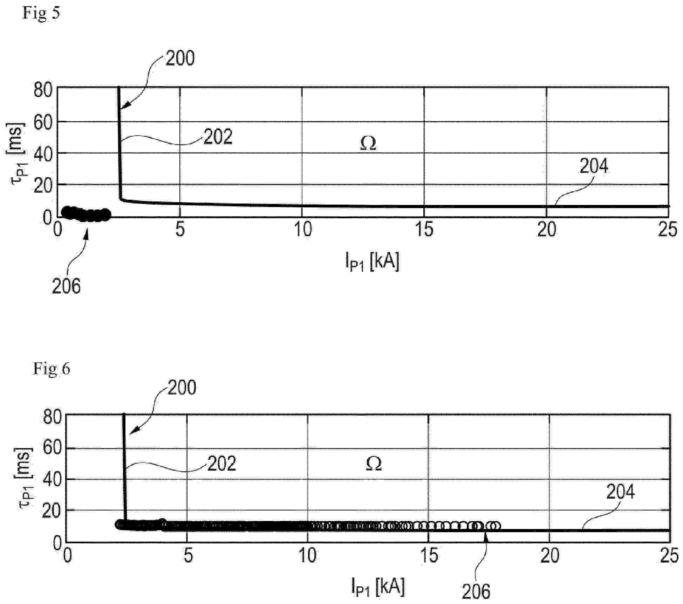

Les figures 5 à 8 montrent des exemples de résultats obtenus avec le procédé décrit ci-dessus.

Sur ces figures 5 à 8 sont représentés en abscisse le premier paramètre $I_\infty$ en kA et en ordonnée le second paramètre $\tau$ en ms.

La région de défaut $\Omega$ est délimitée dans ces graphes par une ligne en trait plein 200 ayant une partie 202 sensiblement parallèle à l'axe des ordonnées et à la valeur de $\tau = 2,5$ ms et une partie 204 sensiblement parallèle à l'axe des abscisses et à la valeur $I_\infty = 10$ kA.

Il est à noter que les parties 202 et 204 peuvent aussi présenter des formes courbes.

Dans ces graphes, un couple ($I_\infty$ / $\tau$) est compris dans une région de défaut appelée $\Omega$ pour détecter un défaut si dans l'exemple $I_\infty > 10$ kA et $\tau > 2,5$ ms.

Les couples de premier et second paramètres ($I_\infty$ / $\tau$) déterminés par la modélisation sont représentés par des cercles (voir flèche 206 comme exemple).

Sur la figure 5 sont représentés des décollements d'un pantographe de véhicule électrique de la ligne 1A d'alimentation électrique. Même si un tel décollement a pour conséquence une élévation de courant importante, il ne s'agit pas d'un défaut qui nécessite la mise en sécurité / isolation de la section d'alimentation électrique concernée. On constate sur la figure 5 qu'effectivement, les couples de premier et second paramètres $(I_\infty / \tau)$ déterminés par la modélisation ne sont pas dans la région de défaut $\Omega$.

Sur la figure 6 sont représentés comme défauts des arrachements de caténaire ayant pour conséquence que les fils sont en contact avec la terre - aucun véhicule électrique n'est raccordé à la ligne aérienne d'alimentation 1A.

On constate sur la figure 6 qu'effectivement, les couples de premier et second paramètres $(I_\infty / \tau)$ déterminés par la modélisation sont dans la région de défaut $\Omega$.

On peut voir que le second paramètre $\tau$ est sensiblement le même pour tous les couples $(I_\infty / \tau)$, tandis que $I_\infty$ peut avoir des amplitudes très importantes allant jusqu'à 18kA.

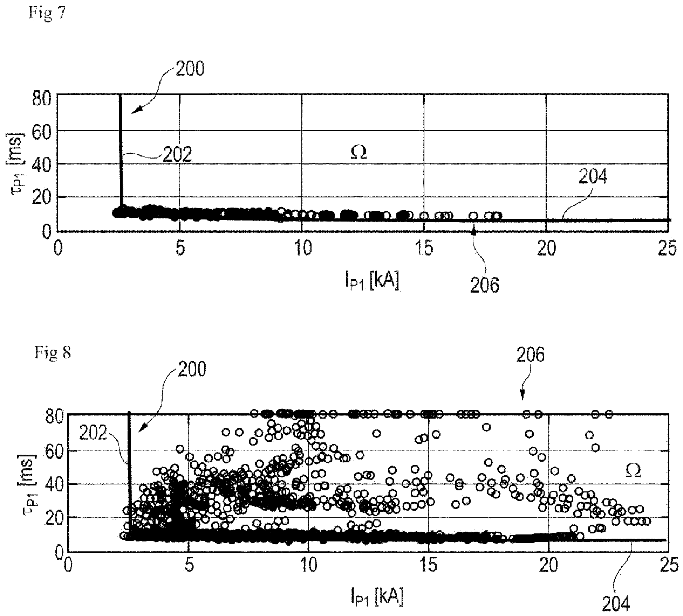

Sur la figure 7 sont représentés comme défaut des arrachements de caténaire de sorte que les fils sont en contact avec la terre - dans cette situation un train est localisé à 12km du défaut dans une section d'alimentation électrique voisine S3, le défaut étant présent sur la section S2.

Les résultats sont similaires à ceux de la figure 6.

On peut voir que le second paramètre $\tau$ est sensiblement le même pour tous les couples $(I_\infty / \tau)$, tandis que $I_\infty$ peut avoir des amplitudes très importantes allant jusqu'à 18kA.

Sur la figure 8 sont représentés comme défaut des arrachements de caténaire avec des fils qui sont en contact avec la terre - dans cette situation un véhicule électrique est localisé à 6km du défaut dans la même section d'alimentation électrique S2.

Les résultats sont dans ce cas spécifique beaucoup plus dispersés que dans les figures précédentes mais on constate encore que la détermination du couple de paramètres $(I_\infty / \tau)$ permet de statuer sur le caractère du défaut et les couples de premier et second paramètres $(I_\infty / \tau)$ déterminés par la modélisation sont dans la région de défaut $\Omega$.

De nombreuses autres situations ont été simulées et testées, par exemple avec deux véhicules électriques dans la même section S d'alimentation électrique avec décollement du pantographe ou arrachement de caténaire par exemple.

Le procédé de détection d'un défaut se distingue par le fait qu'il est fiable et permet la mise en œuvre de façon locale, sans qu'il y ait besoin d'une intervention d'un système central PC de surveillance et de protection. Du fait que le procédé décrit ci-dessus permet de classifier les transitoires observées, on peut éviter en particulier des coupures intempestives des sections d'alimentation électrique.

**Revendications**

1. Procédé de détection d'un défaut sur une section (S) d'une ligne électrique d'alimentation (1A) d'un réseau ferroviaire, comprenant les étapes suivantes :

   - on mesure un courant sur la section (S) en fonction du temps pendant une fenêtre temporelle de mesure d'une durée prédéfinie,
   - on détermine des paramètres d'au moins une fonction (102) de modélisation paramétrable modélisant la courbe de mesure (100) du courant en fonction du temps, cette fonction (102) de modélisation paramétrable présentant une composante croissante asymptotique avec au moins un paramètre définissant la valeur asymptotique du courant en régime établi et au moins un paramètre correspondant à une constante de temps définissant une durée d'établissement du régime établi,
   - on détermine la présence ou non d'un défaut à partir d'au moins certains desdits paramètres déterminés de ladite fonction de modélisation (102) paramétrable.

2. Procédé de détection selon la revendication 1, selon lequel la fenêtre temporelle possède une durée inférieure à 200ms notamment inférieure à 100ms et par exemple comprise entre 30ms et 50ms, en particulier égal à 40ms.

3. Procédé de détection selon la revendication 1 ou 2, selon lequel la composante croissante asymptotique de la fonction est décrite par une fonction du type ( $I_\infty - I_\Delta e^{-\frac{t}{\tau}}$ ), où $I_\infty$ représente le paramètre définissant la valeur asymptotique du courant en régime établi et $\tau$ représente le paramètre correspondant à une constante de temps définissant une durée d'établissement du régime établi.

4. Procédé de détection selon l'une quelconque des revendications 1 à 3, selon lequel ladite fonction de modélisation paramétrable comprend en outre une composante additionnelle oscillatoire.

**5.** Procédé de détection selon la revendication 4, selon lequel ladite fonction de modélisation paramétrable du courant $i_p$(t) en fonction du temps est définie par

$$i_P(t) = p_1 + [I_0 - p_3 \sin(p_5) - p_1]e^{-\frac{t}{p_2}} + p_3 sin(2\pi p_4 t + p_5)$$

avec

$$\begin{cases} p_1 = I_\infty \\ p_2 = \tau \\ p_3 = I_h \\ p_4 = f_h \\ p_5 = \alpha_h \end{cases}$$

où $I_\infty$ représente le paramètre correspondant au courant établi en fin de de régime transitoire,
$\tau$ représente le paramètre correspondant au paramètre de temps permettant de définir la durée du phénomène transitoire,
$I_h$ représente un paramètre correspondant à une amplitude de l'harmonique de courant du phénomène transitoire dans le terme oscillatoire qui peut être égal à $I_\Delta$,
$f_h$ représente un paramètre correspondant à une fréquence dans le terme oscillatoire décrivant le phénomène transitoire et
$\alpha_h$ représente un cinquième paramètre correspondant à une phase du terme oscillatoire décrivant le phénomène transitoire.

**6.** Procédé de détection selon l'une quelconque des revendications 1 à 5, selon lequel ladite fonction du courant ip(t) en fonction du temps est définie par :

$$i_P(t) = p_1 + [I_0 - I_{00} - p_1]e^{-t/p_2} + \sum_{k=1}^{m} p_{3,k} sin(2\pi\ p_{4,k} t + p_{5,k})$$

$$I_{00} = \sum_{k=1}^{m} p_{3,k} sin(p_{5,k})$$

avec : $p_1 = I_\infty$, $p_2 = \tau$ et $p_{3,k}$, $p_{4,k}$ et $p_{5,k}$ des paramètres correspondant respectivement à des amplitudes de courant, des fréquences et des déphasages.

**7.** Procédé selon la revendication 6, selon laquelle on applique aux paramètres déterminés $p_1 = I_\infty$, $p_2 = \tau$ et $p_{3,k}$, $p_{4,k}$ et $p_{5,k}$ une analyse des composantes principales pour obtenir de nouvelles variables décorrélées et en ce que on détermine la présence ou non d'un défaut à partir d'au moins une desdites nouvelles variables décorrélées.

**8.** Procédé selon l'une quelconque des revendications 1 à 7, selon laquelle avant de déterminer la présence ou non d'un défaut, on vérifie si $I_\infty$>$I_0$ et $I_0$> 0, si une de ces inégalités n'est pas vérifiée, on détermine qu'il n'y a pas de défaut.

**9.** Procédé selon l'une quelconque des revendications 1 à 8, selon lequel la modélisation de la courbe de mesure par la fonction de modélisation paramétrable est réalisée par application d'une méthode aux moindres carrées.

**10.** Procédé selon l'une quelconque des revendications 1 à 9, selon lequel on déclenche le début de la fenêtre temporelle de mesure quand le courant mesuré franchi un seuil prédéfini.

**11.** Procédé selon l'une quelconque des revendications 1 à 10, selon lequel on déclenche le début de la fenêtre temporelle de mesure quand la dérivée dans le temps du courant mesuré franchi un seuil prédéfini.

12. Procédé selon l'une quelconque des revendications 1 à 11, selon lequel on détermine la présence ou non d'un défaut en déterminant l'appartenance d'au moins un paramètre déterminé à une région de défaut ($\Omega$) obtenue par un processus d'apprentissage et/ou de classification, à partir de mesures réelles ou obtenues par simulation de défauts sur un modèle d'une section d'alimentation électrique entre deux sous-stations surveillées ou par une combinaison des deux.

13. Dispositif de détection d'un défaut sur une section (S) sur d'une ligne électrique d'alimentation (1A) d'un réseau ferroviaire comprenant un capteur de mesure de courant, **caractérisé en ce que** le dispositif est configuré pour mettre en œuvre un procédé de protection selon l'une quelconque des revendications 1 à 12.

14. Procédé de protection d'une section d'une ligne électrique d'alimentation d'un réseau ferroviaire, dans lequel chaque section est équipée de plusieurs dispositifs de protection (P1, P2, P3), chaque dispositif de protection (P1, P2, P3) comprenant un capteur de mesure de courant et est configuré pour mettre en œuvre un procédé de détection d'un défaut selon l'une quelconque des revendications 1 à 12, et dans lequel on déclenche tous les dispositifs de protection (P1, P2, P3) d'une même section (S2) lorsqu'on a déterminé un défaut par au moins un dispositif de protection.

15. Dispositif de protection (P1, P2, P3) d'une section (S2) d'une ligne électrique d'alimentation d'un réseau ferroviaire comprenant un capteur de mesure de courant et étant configuré pour mettre en œuvre un procédé de protection selon la revendication 14.

**Patentansprüche**

1. Verfahren zur Erkennung eines Fehlers in einem Abschnitt (S) einer elektrischen Versorgungsleitung (1A) eines Schienennetzes, umfassend die folgenden Schritte:

   - Messen eines Stroms in dem Abschnitt (S) abhängig von der Zeit während eines Messzeitfensters mit einer vordefinierten Dauer,
   - Bestimmen von Parametern mindestens einer Funktion (102) zur parametrisierbaren Modellierung, die die Messkurve (100) des Stroms abhängig von der Zeit modelliert, wobei diese Funktion (102) zur parametrisierbaren Modellierung eine asymptotisch ansteigende Komponente mit mindestens einem Parameter, der den asymptotischen Wert des Stroms im eingestellten Zustand definiert, und mindestens einem Parameter, der einer Zeitkonstante entspricht, die eine Einstelldauer des eingestellten Zustands definiert, aufweist,
   - Bestimmen des Vorhandenseins oder Nichtvorhandenseins eines Fehlers anhand mindestens einigen der bestimmten Parameter der Funktion (102) zur parametrisierbaren Modellierung.

2. Erkennungsverfahren nach Anspruch 1, wobei das Zeitfenster eine Dauer von weniger als 200 ms, insbesondere weniger als 100 ms, und beispielsweise zwischen 30 ms und 50 ms, insbesondere gleich 40 ms, aufweist.

3. Erfassungsverfahren nach Anspruch 1 oder 2, wobei die asymptotische steigende Komponente der Funktion durch eine Funktion des Typs ( $I_\infty - I_\triangle e^{-\frac{t}{\tau}}$ ) beschrieben ist, wobei $I_\infty$ den Parameter darstellt, der den asymptotischen Wert des Stromes in dem eingestellten Zustand definiert, und $\tau$ den Parameter darstellt, der einer Zeitkonstante entspricht, die eine Einstelldauer des eingestellten Zustands definiert.

4. Erfassungsverfahren nach einem der Ansprüche 1 bis 3, wobei die Funktion zur parametrisierbaren Modellierung ferner eine zusätzliche oszillatorische Komponente umfasst.

5. Erfassungsverfahren nach Anspruch 4, wobei die Funktion zur parametrisierbaren Modellierung des Stroms $i_p(t)$ abhängig von der Zeit definiert ist durch

$$i_P(t) = p_1 + [I_0 - p_3 \sin(p_5) - p_1] e^{\frac{t}{p_2}} + p_3 \sin(2\pi p_4 t + p_5)$$

mit

$$\begin{cases} p_1 = I_\infty \\ p_2 = \tau \\ p_3 = I_h \\ p_4 = f_h \\ p_5 = \alpha_h \end{cases}$$

, wobei $I_\infty$ der Parameter ist, der dem am Ende der Übergangsphase festgelegten Strom entspricht, $\tau$ den Parameter darstellt, der dem Zeitparameter entspricht, mit dem die Dauer des transienten Phänomens festgelegt wird, $I_h$ einen Parameter darstellt, der einer Amplitude der Stromharmonik des transienten Phänomens in dem oszillatorischen Term entspricht, die gleich $I_\Delta$ sein kann,

$f_h$ einen Parameter darstellt, der einer Frequenz im oszillatorischen Begriff entspricht, der das transiente Phänomen beschreibt, und

$\alpha_h$ einen fünften Parameter darstellt, der einer Phase des oszillierenden Begriffs entspricht, der das transiente Phänomen beschreibt.

6. Erfassungsverfahren nach einem der Ansprüche 1 bis 5, wobei die Funktion des Stroms ip(t) abhängig von der Zeit definiert ist durch:

$$i_p(t) = p_1 + [I_0 - I_{00} - p_1]e^{-t/p_2} + \sum_{k=1}^{m} p_{3,k} \sin\left(2\pi\, p_{4,k} t + p_{5,k}\right)$$

$$I_{00} = \sum_{k=1}^{m} p_{3,k} \sin\left(p_{5,k}\right)$$

mit: $p_1 = I_\infty$, $p_2 = \tau$ und $p_{3,k}$, $p_{4,k}$ und $p_{5,k}$ von Parameter, die jeweils Stromamplituden, Frequenzen und Phasenverschiebungen entsprechen.

7. Verfahren nach Anspruch 6, wobei auf die bestimmten Parameter $p_1 = I_\infty$, $p_2 = \tau$ und $p_{3,k}$, $p_{4,k}$ und $p_{5,k}$ eine Analyse der Hauptkomponenten angewendet wird, um neue unkorrelierte Variablen zu erlangen, und dass das Vorhandensein oder Nichtvorhandensein eines Fehlers aus mindestens einer der neuen unkorrelierten Variablen bestimmt wird.

8. Verfahren nach einem der Ansprüche 1 bis 7, wobei vor Bestimmen des Vorhandenseins oder Nichtvorhandenseins eines Fehlers überprüft wird, ob $I_\infty > I_0$ und $I_0 > 0$, wenn eine dieser Ungleichheiten nicht überprüft wird, bestimmt wird, dass kein Fehler vorliegt.

9. Verfahren nach einem der Ansprüche 1 bis 8, wobei die Modellierung der Messkurve durch die Funktion zur parametrisierbaren Modellierung durch Anwenden eines Verfahrens kleinster Quadrate durchgeführt wird.

10. Verfahren nach einem der Ansprüche 1 bis 9, wobei der Beginn des Messzeitfensters ausgelöst wird, sobald der gemessene Strom einen vordefinierten Schwellenwert überschreitet.

11. Verfahren nach einem der Ansprüche 1 bis 10, wobei der Beginn des Messzeitfensters ausgelöst wird, sobald die zeitliche Ableitung des gemessenen Stroms einen vordefinierten Schwellenwert überschreitet.

12. Verfahren nach einem der Ansprüche 1 bis 11, wobei das Vorhandensein oder Nichtvorhandensein eines Fehlers bestimmt wird, indem die Zugehörigkeit mindestens eines bestimmten Parameters zu einem Fehlerbereich ($\Omega$) bestimmt wird, der durch einen Lern- und/oder Klassifizierungsprozess erlangt wird, basierend auf tatsächlichen Messungen oder erlangt wird durch Simulation von Fehlern an einem Modell eines Stromversorgungsabschnitts zwischen zwei überwachten Unterstationen oder durch eine Kombination von beiden.

13. Vorrichtung zur Erkennung eines Fehlers in einem Abschnitt (S) einer elektrischen Versorgungsleitung (1A) eines Schienennetzes, umfassend einen Strommesssensor, **dadurch gekennzeichnet, dass** die Vorrichtung konfiguriert ist, um ein Schutzverfahren nach einem der Ansprüche 1 bis 12 zu implementieren.

14. Verfahren zum Schutz eines Abschnitts einer elektrischen Versorgungsleitung eines Eisenbahnnetzes, wobei jeder Abschnitt mit mehreren Schutzvorrichtungen (P1, P2, P3) ausgestattet ist, jede Schutzvorrichtung (P1, P2, P3) umfassend einen Strommesssensor und konfiguriert ist, um ein Fehlererkennungsverfahren nach einem der Ansprüche 1 bis 12 zu implementieren, und wobei alle Schutzvorrichtungen (P1, P2, P3) eines gleichen Abschnitts (S2) ausgelöst werden, wenn ein Fehler durch mindestens eine Schutzvorrichtung bestimmt wurde.

15. Schutzvorrichtung (P1, P2, P3) eines Abschnitts (S2) einer elektrischen Versorgungsleitung eines Schienennetzes, umfassend einen Strommesssensor und die zum Durchführen eines Schutzverfahrens nach Anspruch 14 konfiguriert ist.

**Claims**

1. A procedure for detecting a fault on a section (S) of a power supply line (1A) of a railway network, comprising the following steps:

   - a current is measured on the section (S) as a function of time during a measurement time window of a predefined period,
   - parameters of at least one configurable modelling function (102) modelling the measurement curve (100) of the current as a function of time are determined, said configurable modelling function (102) comprising an asymptotically increasing component having at least one parameter defining the asymptotic value of the steady-state current and at least one parameter corresponding to a time constant defining a period of establishment of the steady state,
   - the presence or absence of a fault is determined from at least some of said determined parameters of said configurable modelling function (102).

2. A detection procedure according to Claim 1, wherein the time window comprises a period of less than 200 ms, in particular less than 100 ms and, for example, between 30 ms and 50 ms, in particular equal to 40 ms.

3. A detection procedure according to Claim 1 or 2, wherein the asymptotically increasing component of the function is described by a function of the type ($I_\infty - I_A e^{-\frac{t}{\tau}}$), where $I_\infty$ represents the parameter defining the asymptotic value of the steady-state current, and $\tau$ represents the parameter corresponding to a time constant defining a period of establishment of the steady-state.

4. A detection procedure according to any one of Claims 1 to 3, wherein said configurable modelling function further comprises an additional oscillatory component.

5. A detection procedure according to Claim 4, wherein said configurable modelling function of the current $i_p(t)$ as a function of time is defined by

$$i_P(t) = p_1 + [I_0 - p_3 \sin(p_5) - p_1] e^{\frac{t}{p_2}} + p_3 \sin(2\pi p_4 t + p_5)$$

with

$$\begin{cases} p_1 = I_\infty \\ p_2 = \tau \\ p_3 = I_h \\ p_4 = f_h \\ p_5 = \alpha_h \end{cases}$$

where $I_\infty$ represents the parameter corresponding to the current established at the end of the transient state, $\tau$ represents the parameter corresponding to the time parameter used to define the duration of the transient,

$I_h$ represents a parameter corresponding to an amplitude of the current harmonic of the transient in the oscillatory term which may be equal to $I_\Delta$,

$f_h$ represents a parameter corresponding to a frequency in the oscillatory term describing the transient, and

$\alpha_h$ represents a fifth parameter corresponding to a phase of the oscillatory term describing the transient.

6. A detection procedure according to any one of Claims 1 to 5, wherein said function of the current ip(t) as a function of time is defined by:

$$i_p(t) = p_1 + [I_0 - I_{00} - p_1]e^{-t/p_2} + \sum_{k=1}^{m} p_{3,k} \sin\left(2\pi\, p_{4,k}t + p_{5,k}\right)$$

$$I_{00} = \sum_{k=1}^{m} p_{3,k} \sin\left(p_{5,k}\right)$$

with: $p_1 = I_\infty$, $p_2 = \tau$ and $p_{3,k}$, $p_{4,k}$ and $p_{5,k}$ parameters corresponding respectively to current amplitudes, frequencies and phase shifts.

7. A procedure according to Claim 6, wherein an analysis of the main components is applied to the determined parameters $p_1 = I_\infty$, $p_2 = \tau$ and $p_{3,k}$, $p_{4,k}$ and $p_{5,k}$ in order to obtain new decorrelated variables, and in that the presence or absence of a defect is determined from at least one of the said new decorrelated variables.

8. A procedure according to any one of Claims 1 to 7, wherein , before determining the presence or absence of a fault, it is checked whether $I_\infty > I_0$ and $I_0 > 0$; if one of these disparities is not verified, it is determined that there is no fault.

9. A procedure according to any one of Claims 1 to 8, wherein the modelling of the measurement curve by the configurable modelling function is performed by applying a least-squares method.

10. A procedure according to any one of Claims 1 to 9, wherein the start of the measurement time window is triggered when the measured current crosses a predefined threshold.

11. A procedure according to any one of Claims 1 to 10, wherein the start of the measurement time window is triggered when the time derivative of the measured current crosses a predefined threshold.

12. A procedure according to any one of Claims 1 to 11, wherein the presence or absence of a fault is determined by determining whether at least one determined parameter belongs to a fault region ($\Omega$) obtained by a learning and/or classification process, from actual measurements or obtained via the simulation of faults on a model of a power supply section between two monitored substations or via a combination of the two.

13. A device for detecting a fault on a section (S) of a power supply line (1A) of a railway network comprising a current measurement sensor, **characterized in that** the device is configured to implement a protection procedure according to any one of Claims 1 to 12.

14. A procedure for protecting a section of a power supply line of a railway network, wherein each section is configured with a plurality of protection devices (P1, P2, P3), each protection device (P1, P2, P3) comprising a current measurement sensor and being configured to implement a procedure for detecting a fault according to any one of Claims 1 to 12, and wherein all the protection devices (P1, P2, P3) of the same section (S2) are triggered when a fault has been determined by at least one protection device.

15. A protection device (P1, P2, P3) of a section (S2) of a power supply line of a railway network comprising a current measurement sensor and being configured to implement a protection procedure according to Claim 14.

Fig 1

Fig 2

Fig 3

Fig 4

Fig 5

Fig 6

Fig 7

Fig 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2012004867 A1